(19) Europäisches Patentamt

European Patent Office

Office européen des brevets

(11) **EP 2 216 229 A2**

(12) **EUROPEAN PATENT APPLICATION**

(43) Date of publication:
**11.08.2010 Bulletin 2010/32**

(51) Int Cl.:
***B61L 1/18*** *(2006.01)* ***B61L 1/20*** *(2006.01)*

(21) Application number: **10152007.0**

(22) Date of filing: **28.01.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **06.02.2009 GB 0901881**

(71) Applicant: **Balfour Beatty PLC**
**London SW1V 1LQ (GB)**

(72) Inventor: **Josse, Valentin**
**Derby, Derbyshire DE1 2SA (GB)**

(74) Representative: **Ertl, Nicholas Justin**
**Elkington and Fife LLP**
**Prospect House**
**8 Pembroke Road**
**Sevenoaks**
**Kent TN13 1XR (GB)**

(54) **Apparatus and method for monitoring insulated rail joints**

(57) A device for monitoring an insulated joint between sections of rail comprises a monitoring arrangement for monitoring current flow between two points along a rail in the vicinity of the rail joint by measuring voltages at the two points.

FIG. 3

**EP 2 216 229 A2**

## Description

This invention relates to an apparatus and method for monitoring a rail joint, in particular a so-called insulated block joint, otherwise known as an insulated rail joint, and referred hereinafter "IBJ".

Rail signalling systems are designed and implemented to allow the safe passage of trains throughout the railway network. Track circuits play a major role within the interlocking as they indicate the presence of a rail vehicle. Track circuits can be divided into two groups; jointless track circuits and track circuits separated by Insulated Block Joints. These insulated joints enable isolated sections of rails to be used as part of the track circuits.

The track circuits play a vital role, and it is therefore important to be able to identify any faulty components. The applicant has identified that one of the elements which poses the most problem is the IBJ.

This invention relates specifically to an apparatus for monitoring the state of an IBJ.

## Summary of the invention

According to the invention, there is provided a device for monitoring an insulated joint between sections of rail, comprising a monitoring arrangement for monitoring current flow between two points along a rail in the vicinity of the rail joint by measuring voltages at the two points.

This arrangement can be installed temporarily or permanently. It can be installed permanently without causing obstruction to the rail traffic, as it simply requires electrical contact to the rail, for example underneath the foot of the rail. Thus, the invention provides an in-situ monitoring arrangement which does not cause any disruption to the rail service. The monitoring specifically identifies reduced insulating properties of the insulated joint, and this can enable the potential fault to be identified before false track circuit signals are produced.

The monitoring arrangement preferably comprises an amplifier for amplifying a voltage difference between the points. A high gain amplifier enables the small currents flowing along the rail and across the insulated joint to be detected.

Two sensors can be provided for connection to the two points along the rail, and each sensor can have a fault detection switch, and wherein the monitoring arrangement is further for monitoring the fault detection switches. This provides an auto-test capability to check that the sensors are correctly in contact with the rail, and this is desirable because of the harsh conditions in the vicinity of the rail - including weather conditions and vibrations.

The invention also provides a rail track circuit, comprising:

a power supply for supplying current to a rail section to a first location in the vicinity of a first insulated joint at a first end of the rail section;
a relay for sensing a current flow and connected to a second location in the vicinity of a second insulated joint at a second end of the rail section; and
a monitoring device of the invention, connected between the first location and the first end, or between the second location and the second end.

This combines a relay track circuit with the monitoring device of the invention. The monitoring device can be an add-on to an existing track circuit, or it may be installed as part of a new track circuit. The two points along the rail are preferably separated by a distance corresponding to the distance between sleepers of the rail track. For example, the separation may be between 100mm and 600mm.

The invention also provides a method of monitoring an insulated joint between sections of rail, comprising:

monitoring current flow between two points along a rail in the vicinity of the rail joint by measuring voltages at the two points.

## Brief description of the drawings

An example of the invention will now be described in detail with reference to the accompanying drawings, in which:

Figure 1 shows a known track circuit arrangement;
Figure 2 shows how the monitoring device of the invention is connected to the rails;
Figure 3 shows the monitoring device of the invention in more detail;
Figure 4 shows how sensors used in the monitoring device can in one example be connected to the rail;
Figure 5 shows how the components of the monitoring device are housed;
Figure 6 is a circuit board showing the different electronic components used in the monitoring device; and
Figure 7 shows one possible noise filtering arrangement for use as part of the apparatus of the invention.

**Detailed description**

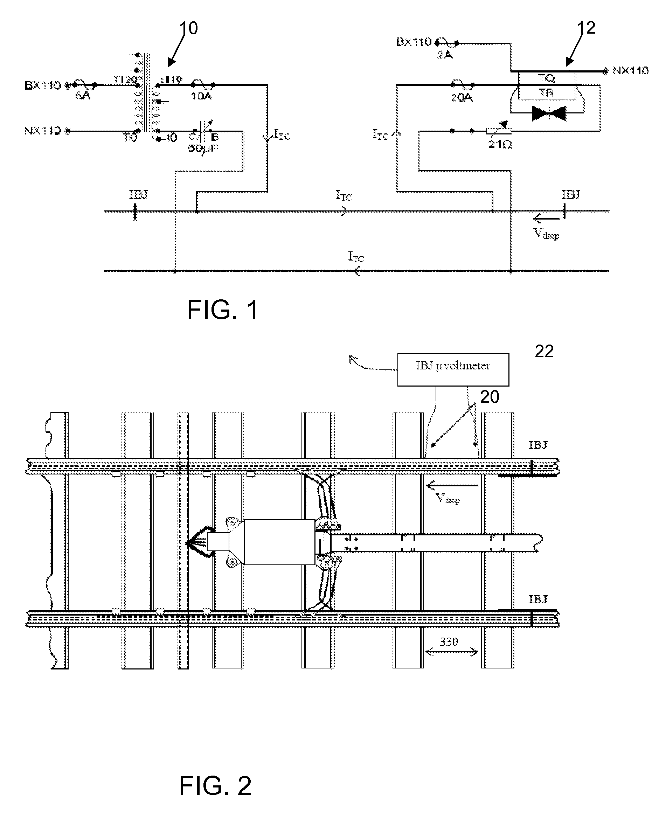

Before describing the invention in detail, the electrical values which are brought into play within an IBJ track circuit are first explained, with reference to Figure 1. This shows a so-called "VT1 track circuit. The invention will be described in connection with this circuit, although the invention is applicable to other types of track circuit using IBJs.

The basic principle behind the track circuit lies in the connection of the two rails by the wheels and axle of the train to short out an electrical circuit. This circuit is monitored by electrical equipment to detect the presence or absence of the trains. Since this is a safety appliance, the circuit is designed to indicate the presence of a train when failures occur. On the other hand, false occupancy readings are disruptive to railroad operations and are to be minimized.

Track circuits allow railway signalling systems to operate semi-automatically, by displaying signals for trains to slow down or stop in the presence of occupied track ahead of them.

The track circuit has power applied to each rail by the transformer 10. A relay coil 12 is wired across the rails. Each circuit detects a defined section of track, termed a block. These sections are separated by the IBJs shown in one rail in Figure 1 (but typically in both rails).

When no train is present, the relay is energised by the current flowing from the power source through the rails. When a train is present, its axles short the rails together, so that the relay is bypassed and the current to the track relay coil drops. It is then de-energised. A drop in current thus indicates that the track is occupied.

In the event of failure of the IBJ, one circuit may power the next so that the presence of train in the next track is not detected. The electrical polarity is reversed from section to section to avoid this problem. The circuits can be battery-powered or transformer powered at low voltages such as 1.5 to 12 V DC to protect against line power failures. The relay 12 and the power supply 10 are attached to opposite ends of the section in order to prevent broken rails from electrically isolating part of the track from the circuit.

The rail is not perfect in terms of its mechanical aspects or its electrical aspects and this is used by the system of the invention to provide a detection capability. When there is no train on a track circuit, the current which picks up the relay, $I_{TC}$, does not exceed 1A. When a train comes, the rail current can increase to around 1.6A (because of the shorter conduction path due to the axle's short circuit). This increased current does not flow through the relay, however.

The electrical resistance of the rail is around 0,3Ω/km, so that for a given distance, a voltage is associated. Obviously this voltage is very low, and particularly for a short distance, such as 330mm, which is the average distance between two sleepers.

In order to give an idea of the expected voltage, by taking in account the maximum parameter values (rail to rail impedance, feed transformer impedance, relay impedance, etc.), the value is around:

$$V_{drop} = \left( \frac{R_{rail}}{10^6} * 330mm \right) * I_{TC} = 100\mu\Omega * 1,6A = 160\mu V$$

The invention provides a system which measures this voltage drop along a rail, particularly between the IBJ and the connection of the feed or relay to the rails. This voltage drop is shown as "Vdrop" in Figure 1.

The invention provides a voltmeter between the IBJ and the connection, for example between the two last sleepers which precede the IBJ. Figure 2 shows the arrangement of the invention.

Sensors 20 are provided with a separation corresponding to the sleeper separation. A voltmeter 22 receives signals from the two sensors.

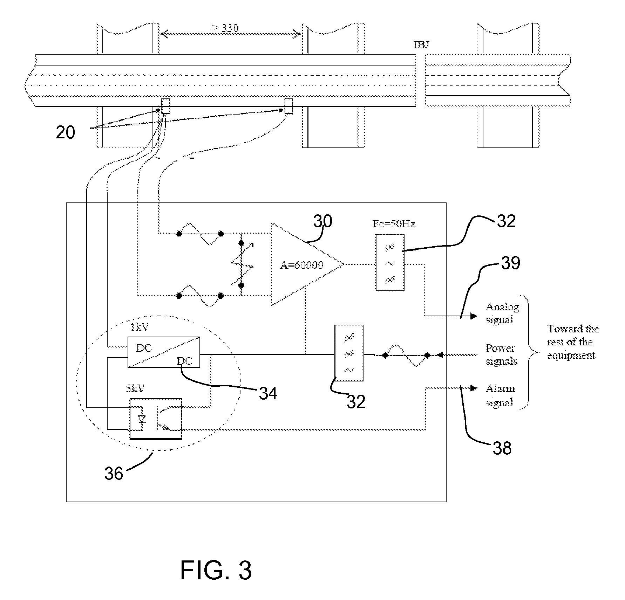

The voltmeter functions as a high gain amplifier, which is able to multiply an input voltage by around 60000, as shown in Figure 3. The voltmeter comprises the differential amplifier 30, and frequency filters 32. The voltmeter 22 powers the sensors 20 through isolation circuits 34 and also has a monitoring arrangement 36 for detecting sensor failure to provide an alarm signal 38.

When the IBJ is providing good insulation, there will be much lower current in the rail section before the IBJ. Only in the event of an IBJ failure will a current flow from one track section to the next, with the maximum current that can flow as outlined above.

If a 160μV voltage is presented across the voltmeter sensors 20 (which based on the example above is the maximum that could arise), an output of a 1V signal is provided at the output terminal 39 with noises suppressed. The voltmeter is for example designed to enable measurement of the voltage produced by a current as low as 100mA current flowing in the 300mm length of rail. Therefore, this enables accurate analysis of the monitored IBJ electrical performance for a range of possible leakage currents.

The voltmeter is connected to the rail and therefore particular safety precautions are required. Because the voltmeter is in constant contact with the rail, linear fuses and a surge arrester can be included, to protect against sparks and overloads.

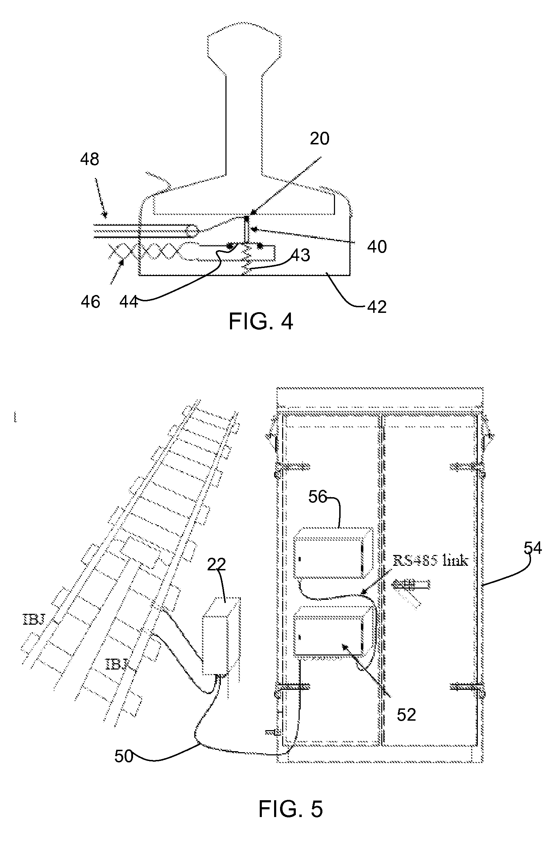

The sensors need to be well clipped to the rail, and one possible arrangement is shown in Figure 4. The sensor is mounted in an insulated stem 40 within a housing 42 that clips to the rail. The sensor is spring biased (spring 43) against the rail surface, and movement of the sensor is detected by a switch 44 to provide the alarm signal 38 as explained above. The alarm signal can be provided over a twisted cable 46, and the sensor signal is preferably provided over an armoured cable 48. The cable linking the IBJ voltmeter to the rest of the equipment is a copper trackside cable 50 as shown in Figure 5.

The sensors are supplied by isolated power supplies as explained above.

Due to the low measured voltage and the perturbed environment, the voltmeter is provided in a shielded box 42, itself included in an IP68 polyester enclosure.

The system can be formed in a modular manner, for example with up to eight IBJ voltmeters monitored by an electronic analyser 52. If the voltmeters are situated beside the track, the electronic analyser 52 is located in a railway cupboard 54. The analyser can be small (e.g. 200 x 300 x 150mm). The system is fed by the main supply (110V/240V 50Hz), and it communicates with the other railway equipment 56 via a RS485 protocol.

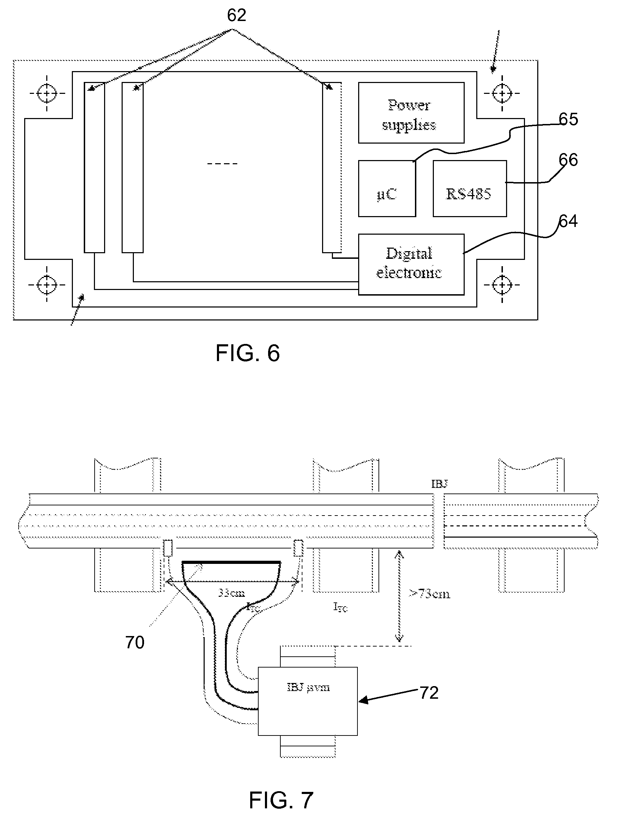

The electronic analyser 52 preferably has a steel case. As shown in Figure 6, it contains PCBs 62 (hereinafter insulated barrier PCB) for each voltmeter, and the shared electronics analyser PCB. The analyser comprises digital electronics components 64 and a microcontroller 65, which provides power signals to the sensors. The calculation results are sent to the other railway devices via a RS485 link 66. The microcontroller can implement fast Fourier transforms and can be configured to generate alarms when the monitored IBJ is failing.

The insulated barrier PCBs provide an electrical isolation of more than 1kV between an IBJ voltmeter and the rest of the device. Each voltmeter has provided an associated IBJ Insulated Barrier PCB. Thus, if only four IBJ voltmeters are used by the device, just four insulated barrier PCBs will be necessary. This enables an adaptable modular system.

The system preferably provides a real time analysis of the amplitude, and the real and imaginary components and flow direction of the IBJ current. An interrupt signal can be generated when the current is too high and considered as abnormal. This abnormal level is determined and set by the microcontroller.

The system preferably includes noise filtering to improve the resolution of the output signal and therefore produce a more accurate alarm threshold.

Figure 7 shows one possible noise filtering arrangement. A cable loop antenna 70 is placed between the sleepers and connected to the IBJ monitoring system 72. The noise measured on this antenna is fed into the filtering and amplification system (of Figure 3) and is used as a feedback parameter to remove the equivalent noise measured in the rail. As the antenna loop is not connected to the rail, any track circuit current measured in the rail will not be found in the signal from the antenna loop. Utilising Common Mode Rejection techniques, it is possible to filter any noise that is measured equally in both the rail and the antenna.

The antenna can be mounted in any desired orientation, although a vertical orientation has proven to provide the best feedback operation.

The output from the monitoring system then has a low level or no unwanted noise resulting in an increased level of resolution in the output signal and the potential for a more sensitive alarm threshold.

The invention provides a new measurement tool for monitoring a track circuit fitted with insulated block joints. It provides the first solution giving observation, in real time, of the state of an insulated block joint. This is achieved without connection between the monitored track circuit and its neighbouring track circuit. Therefore, it guarantees a total safety of the track circuit.

Interrupt routines can be used by the microcontroller, to enable the system to catch and to analyse all changes in IBJ conditions. These conditions depend for example on the weather (humidity, temperature), and the interrupt level can be constantly tuned taking this into account.

The system can be designed to have a long life, need minimal maintenance, consume little energy, and have excellent temperature resilience (for example working from -20°C to 70°C). Moreover, the silicon IC components enable small dimensions, and therefore the electronic analyser can be mounted in a small railway cupboard.

The system can be powered by the mains (110V or 240V) or the low power consumption also enables power to be supplied by means of a battery with solar charging.

The system is flexible and in one example can be configured to supervise up to eight IBJs; giving a cost effective solution.

The monitoring arrangement can be provided as an add-on to an existing track circuit, or it can be installed with a new track circuit. It does not require any additional current to be provided to the rail, as it simply uses the existing track circuit current. Thus, it does not interfere in any way with normal track circuit functions.

Various modifications will be apparent to those skilled in the art.

**Claims**

1. A device for monitoring an insulated joint between sections of rail, comprising a monitoring arrangement for monitoring current flow between two points along a rail in the vicinity of the rail joint by measuring voltages at the two points.

2. A device as claimed in claim 1, wherein the monitoring arrangement comprises an amplifier for amplifying a voltage difference between the points.

3. A device as claimed in claim 1 or 2, further comprising two sensors for connection to the two points along the rail, and wherein each sensor has a fault detection switch, and wherein the monitoring arrangement is further for monitoring the fault detection switches.

4. A device as claimed in any preceding claim, further comprising a noise filtering arrangement for reducing noise in the monitored current flow signal.

5. A device as claimed in claim 4, wherein the noise filtering arrangement comprises a cable antenna in the vicinity of the monitoring arrangement for generating a feedback signal for noise cancellation purposes.

6. A rail track circuit, comprising:

   a power supply for supplying current to a rail section to a first location in the vicinity of a first insulated joint at a first end of the rail section;
   a relay for sensing a current flow and connected to a second location in the vicinity of a second insulated joint at a second end of the rail section; and
   a monitoring device as claimed in any preceding claim, connected between the first location and the first end, or between the second location and the second end.

7. A circuit as claimed in claim 6, wherein the two points along the rail are separated by a distance corresponding to the distance between sleepers of the rail track.

8. A method of monitoring an insulated joint between sections of rail, comprising:

   monitoring current flow between two points along a rail in the vicinity of the rail joint by measuring voltages at the two points.

9. A method as claimed in claim 8, the monitoring comprises amplifying a voltage difference between the points.

10. A method as claimed in claim 8 or 9, further comprising monitoring fault detection switches associated with sensors provided at the points.

11. A method as claimed in claim 8, 9 or 10, further comprising:

    supplying current to a rail section to a first location in the vicinity of a first insulated joint at a first end of the rail section;
    sensing a current flow from a second location in the vicinity of a second insulated joint at a second end of the rail section; and
    wherein the monitoring of the current flow between two points is in respect of a section of rail between the first location and the first end, or between the second location and the second end.

FIG. 1

FIG. 2

FIG. 3

48

20

40

43

46  44  42

FIG. 4

56

22

RS485 link

54

IBJ

IBJ

52

50

FIG. 5

62

Power supplies

µC

RS485

Digital electronic

65

66

64

FIG. 6

IBJ

33cm

I$_{TC}$

>73cm

I$_{TC}$

IBJ µvm

70

72

FIG. 7